# EUROPÄISCHE PATENTSCHRIFT

(11) **EP 0 561 300 B1**
(45) Veröffentlichungstag und Bekanntmachung des Hinweises auf die Patenterteilung: **13.01.1999**
(21) Anmeldenummer: 93104068.7
(22) Anmeldetag: 12.03.1993
(51) Int. Cl.: H01L 21/00

(54) **Anordnung zum Entfernen von Photolack von der Oberfläche von Halbleiterscheiben**
Device for stripping photoresist from the surface of a semi-conductor water
Dispositif pour enlever une résine photosensible de la surface d'une plaque de semi-conducteur

(30) Priorität: 19.03.1992 DE 4208920
(43) Veröffentlichungstag der Anmeldung: 22.09.1993
(73) Patentinhaber: TEXAS INSTRUMENTS DEUTSCHLAND GMBH, 85356 Freising (DE)
(72) Erfinder: Endl, Helmut, 8050 Freising (DE); Rinck, Helmut, 8052 Moosburg (DE)
(74) Vertreter: Schwepfinger, Karl-Heinz, Dipl.-Ing.

(56) Entgegenhaltungen:
- EP-A- 0 187 249
- WO-A-92/00601
- US-A- 5 002 010

## Beschreibung

Die vorliegende Erfindung betrifft eine Anordnung zum Entfernen von Photolack von der Oberfläche von Halbleiterscheiben, in denen integrierte Schaltungen ausgebildet sind, mit einer Einführungsvorrichtung zum Einführen einer Halbleiterscheibe in eine Behandlungskammer, einer Trockenätzvorrichtung in der Behandlungskammer, durch die der zu entfernende Photolack mittels eines Plasmas abgeätzt wird, und einer Entnahmevorrichtung, die die Halbleiterscheibe aus der Behandlungskammer entfernt.

Im Verlauf der Strukturierung von Leiterbahnen und insbesondere von Aluminiumlegierungsleiterbahnen auf integrierten Schaltungen, die in der Oberfläche von Halbleiterscheiben gebildet werden, werden Trockenätzverfahren eingesetzt. Die dabei verwendeten korrosiven, chlorhaltigen Gase und deren Reaktionsprodukte werden an den Metalloberflächen der Leiterbahnen adsorbiert und führen unter Feuchteeinwirkung zur Korrosion der Metallleiterbahnen. Die Korrosion ist um so stärker, je unedler das zur Ausbildung der Leiterbahnen verwendete Metall ist. Insbesondere wird die unter Feuchteeinwirkung eintretende Korrosion noch verstärkt, wenn das zur Ausbildung der Leiterbahnen verwendete Metall das unedle Aluminium ist und dieses mit edleren Metallen in Kontakt steht.

Um die Halbleiterscheiben für eine Weiterverarbeitung nach dem Ätzen der Leiterbahnen vorzubereiten, muß der bei der Strukturierung der Leiterbahnen eingesetzte Photo lack restlos wieder von allen Metalloberflächen einer Halbleiterscheibe entfernt werden. Bei einer bekannten Anlage zum Entfernen von Photo lack werden die Halbleiterscheiben in eine Kammer eingeführt, in der der Photolack durch Anwendung eines Trockenätzverfahrens entfernt wird. In der Fachterminologie wird dieses Ätzen auch "Veraschen" genannt. Die Halbleiterscheiben (Wafer) werden magazinweise aus einer Trockenätzanlage, in der die Metalleiterbahnen auf der Oberfläche der Halbleiterscheibe mittels eines Plasmas erzeugt worden sind, in einem jeweils eine Gruppe von Halbleiterscheiben enthaltenden Magazin zu einer Behandlungskammer befördert, in der sie einzeln, nacheinander dem mittels eines Plasmas durchgeführten Ätzvorgang unterworfen werden. Während dem Veraschen des Photolacks auf einer Halbleiterscheibe in dieser Kammer sind die anderen, noch außerhalb der Kammer in dem Magazin gelagerten Halbleiterscheiben der Umgebungsatmosphäre ausgesetzt, in der sie wegen der auf ihnen vom vorausgegangenen Ätzvorgang noch vorhandenen korrosiven Reaktionsprodukte sehr rasch korrodieren. Um die Korrosion der Halbleiterscheiben einzudämmen, müssen die Wartezeiten der Halbleiterscheiben bis zum Veraschen verkürzt werden. Zur Verkürzung der Wartezeiten wird der Veraschungsvorgang so schnell wie möglich durchgeführt, so daß die die Korrosion verursachenden korrosiven Reaktionsprodukte nicht gänzlich desorbiert werden. Folglich korrodieren die Leiterbahnen auf den Halbleiterscheiben nach dem Veraschen, also nach der Entnahme aus der Behandlungskammer weiter. Somit ist es mit der bekannten Anlage nicht möglich, die Korrosion der Metalleiterbahnen auf den Halbleiterscheiben vor und nach dem Veraschen auszuschalten.

Aus der EP-A-0 187 249 ist eine Anordnung zur Behandlung von Halbleiterscheiben bekannt, die aus mehreren aneinandergereihten Kammern besteht, beispielsweise einer Beladekammer, einer Ätzkammer und einer Entladekammer. Jede Kammer ist an eine Vakuumpumpe angeschlossen, und die einzelnen Kammern sind über Schleusen miteinander verbunden. Die Anordnung ist dafür ausgelegt, die Halbleiterscheiben, die mittels einer Transportvorrichtung von einer Kammer zur nächsten bewegt werden, einzeln zu behandeln. Die Halbleiterscheiben, die gerade nicht bearbeitet werden, befinden sich in Magazinen außerhalb der Kammern.

Aus der US-A-5 002 010 ist eine Anordnung zur Vor- und Nachbehandlung von Halbleiterscheiben innerhalb einer Hauptvakuumkammer bekannt. In der Hauptvakuumkammer befinden sich zwei bewegbare Teile, die in geschlossenem Zustand eine luftdicht abgeschlossene Kammer bilden. Darin befindet sich ein Halter für eine Halbleiterscheibe. Die innere Kammer ist an eine Vakuumpumpe und eine Gaszuleitung angeschlossen. Dadurch kann die Halbleiterscheibe geheizt oder gekühlt werden, ohne daß das Vakuum in der Hauptvakuumkammer beeinträchtigt wird. Die innere Kammer wird im geöffneten Zustand mittels eines Ladearms be- und entladen. Die zu behandelnden Halbleiterscheiben sind in einem Magazin in der Hauptvakuumkammer angeordnet.

Aus der WO-A-9 200 601 und EP-A-0 489 179 ist ein Verfahren bekannt, mit dem die Korrosion der Leiterbahnen und Elektroden nach dem Trockenätzen verhindert werden soll, indem das zum Veraschen verwendete Plasma in einer aus Sauerstoff und Wasserdampf bestehenden Atmosphäre erzeugt wird oder das Substrat nach dem Veraschen einem aus Wasserdampf erzeugten Plasma ausgesetzt wird. Das Trockenätzen der Leiterbahnen, das Veraschen und die Nachbehandlung erfolgen in verschiedenen Kammern, die jeweils an Vakuumquellen angeschlossen und durch Ladeschleusenkammern miteinander verbunden sind. Dabei wird nur ein Substrat auf einmal behandelt.

Aus "VLSI Technology", S. M. Sze, 2. Ausgabe, 1988, S. 212 bis 221 sind Trockenätzverfahren bekannt, bei denen sich die Magazine, die die zu behandelnden Halbleiterscheiben enthalten, in einer Ladeschleusenkammer befinden, damit beim Be- und Entladen die Ätzkammer nicht belüftet wird.

Daher ist es Aufgabe der vorliegenden Erfindung, eine Anordnung zum Entfernen von Photolack von der Oberfläche von Halbleiterscheiben herzustellen, mit der eine Korrosion der Leiterbahnen vor und nach dem Entfernen des Photolacks weitgehend verhindert wird.

Diese Aufgabe wird erfindungsgemäß durch die im Kennzeichen des Patentanspruchs 1 aufgeführten Merkmale gelöst.

Der mit der Erfindung erzielte Vorteil besteht darin, daß die Korrosion der Leiterbahnen durch das Unterbringen der Einführungs- und der Entnahmevorrichtung in eine unter Vakuum stehende Kammer ausgeschaltet wird.

Eine vorteilhafte Weiterbildung der Erfindung ist in dem Unteranspruch 2 angegeben.

Die Erfindung wird im folgenden anhand der Zeichnung näher beschrieben. Die einzige Figur der Zeichnung zeigt eine Anordnung zum Entfernen von Photolack von der Oberfläche von Halbleiterscheiben.

Die dargestellte Anordnung dient zum Entfernen von Photolack von der Oberfläche von Halbleiterscheiben 1, sie besteht im wesentlichen aus drei Kammern: einer Beladekammer 2a mit einer Einführungsvorrichtung 4, einer Behandlungskammer 3 und einer Entladekammer 2b, innerhalb welcher eine Entnahmevorrichtung 15 zum Entfernen der Halbleiterscheiben 1 aus der Behandlungskammer 3 angeordnet ist.

Die Halbleiterscheiben 1, die in einem nicht dargestellten Magazin untergebracht sind, werden unmittelbar nach einem Trockenätzverfahren in die Beladekammer 2a befördert, damit die auf den Halbleiterscheiben 1 bei diesem Trockenätzverfahren ausgebildeten Leiterbahnen nicht schutzlos dem Umgebungsklima ausgesetzt sind. Die Beladekammer 2a ist unmittelbar neben einer Seitenwand der Behandlungskammer 3 angeordnet und mit dieser über eine Druckschleuse 6a verbunden. Innerhalb der Beladekammer 2a ist die Einführungsvorrichtung 4 zum Einführen der Halbleiterscheiben 1 in die Behandlungskammer 3 angeordnet. Die Einführungsvorrichtung 4 weist eine nicht dargestellte Einrichtung auf, mit der das die Halbleiterscheiben enthaltende Magazin in vertikaler Richtung bewegt werden kann, wie durch den Pfeil R1 angezeigt wird. Die Einführungsvorrichtung 4 weist ferner einen um eine Achse Al drehbaren Transportarm 4a auf, mit dem die Halbleiterscheiben 1 einzeln durch die Druckschleuse 6a in die Behandlungskammer 3 eingeführt werden. Um die Beladekammer 2a an eine Vakuumquelle anzuschließen, ist die Beladekammer 2a mit einer Rohrleitung 9 versehen.

Die Behandlungskammer 3 enthält die Trockenätzvorrichtung, mit deren Hilfe Photolack von der Oberfläche der Halbleiterscheibe 1 entfernt wird. Ein Teil der Trockenätzvorrichtung ist eine Heizvorrichtung in Form eines Heiztischs 5, auf der die Halbleiterscheiben 1 zur Durchführung des Trockenätzvorgangs zum Entfernen des noch auf den Halbleiterscheibenoberflächen vorhandenen Photolacks von dem Transportarm 4a abgelegt werden. Bei dem Trockenätzvorgang wird über eine Zuleitung 13 ein geeignetes Prozeßgas eingeleitet, aus dem mittels einer durch eine HF-Einkopplungsvorrichtung 12 zugeführten HF-Energie ein Plasma erzeugt wird. Der Heiztisch 5 weist eine rohrförmige Stütze 11 auf, durch die Zuleitungen 8 zu einem im Heiztisch 5 untergebrachten Heizelement 16 geführt sind. Die Stütze 11 ist an der Behandlungskammer 3 so befestigt, daß der Heiztisch 5 in Richtung des Pfeils R6 angehoben und abgesenkt werden kann. Über eine Rohrleitung 14 ist die Behandlungskammer an eine Vakuumquelle angeschlossen.

Unmittelbar neben einer der Beladekammer 2a gegenüberliegenden Seitenwand ist die Entladekammer 2b angeordnet, die über eine in dieser Seitenwand vorgesehene Druckschleuse 6b mit der Behandlungskammer 3 verbunden ist. Durch diese Druckschleuse 6b können die Halbleiterscheiben 1 aus der Behandlungskammer 3 in die Entladekammer 2b transportiert werden. In der Entladekammer 2b befindet sich die Entnahmevorrichtung 15, die ein nicht dargestelltes Aufnahmemagazin für die Halbleiterscheiben 1 und einen, um eine Achse A2 drehenden Transportarm 4b aufweist. Das Aufnahmemagazin ist in Richtung des Pfeils R2 beweglich, damit der Transportarm 4b eine Scheibe 1 nach der anderen in das Magazin einschieben kann. Über eine Rohrleitung 10 ist die Entladekammer 2b an eine dritte Vakuumquelle angeschlossen. In der Entladekammer 2b ist ferner eine weitere Heizvorrichtung 7 vorgesehen, die an einer der Seitenwände der Entladekammer 2b angebracht ist und zum Einstellen der Temperatur in der Entladekammer dient.

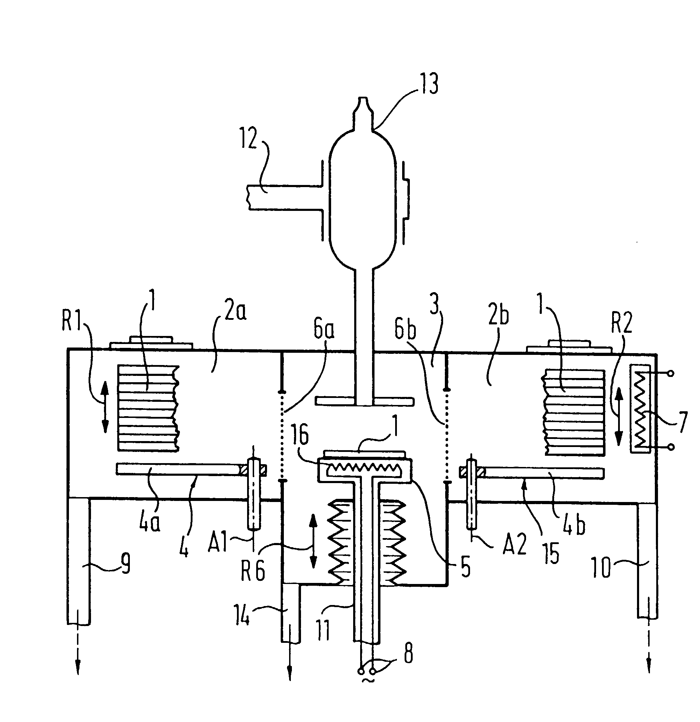

Im folgenden werden nun die einzelnen Arbeitsschritte beschrieben, die mittels der Anordnung aus Fig. 1 durchgeführt werden. Zunächst werden die Halbleiterscheiben in die Beladekammer 2a befördert und zwischengelagert. Die Beladekammer steht unter Vakuum, wodurch eine Korrosion der metallischen Leiterbahnen verhindert wird. Danach werden die in der Beladekammer 2a gestapelten Halbleiterscheiben 1 einzeln mittels des Transportarms 4a durch die Druckschleuse 6a hindurch in die Behandlungskammer 3 eingeführt und auf dem Heiztisch 5 abgelegt. Der Heiztisch 5 ist dabei auf eine Temperatur von etwa 300 bis 400°C vorgeheizt. Das das Veraschen des Photolacks bewirkende Plasma wird in der Behandlungskammer 3 für eine Zeitdauer von etwa 30 s bis 60 s zur Einwirkung gebracht. Danach wird die Halbleiterscheibe 1 aus der Behandlungskammer 3 mittels des Transportarms 4b entfernt und in der Entladekammer 2b überführt. Die Entladekammer 2b ist mittels der Heizung 7 auf eine Temperatur von etwa 300°C aufgeheizt, um das Desorbieren der Rückstände des Veraschungsvorgangs auf der Halbleiterscheibe 1 zu erleichtern. Um alle korrosiven Rückstände möglichst vollständig durch Desorption unwirksam zu machen, soll die Verweilzeit in der Entladekammer 2b etwa fünfmal so lange wie die Plasmabehandlung in der Behandlungskammer 3 dauern. Schließlich werden die in der Entnahmevorrichtung 2b gestapelten Halbleiterscheiben 1 aus der Entladekammer 2b entfernt und gegebenenfalls weiterverarbeitet.

Die beschriebene Anordnung weist gemäß den obigen Erläuterungen drei getrennte Kammern auf, die jeweils an Vakuumquellen angeschlossen sind. Da die Vakuumquellen unterschiedliche Unterdrücke in den Kammern erzeugen können, sind die Druckschleusen 6a und 6b zwischen den Kammern erforderlich. Bei der erfindungsgemäßen Anordnung sind die Trennwände zwischen den Kammern entfernt, so daß eine Kammer entsteht, die an nur eine Vakuumquelle angeschlossen werden muß. Bei dieser Anordnung erübrigen sich die Druckschleusen, da keine Druckunterschiede zwischen den einzelnen Abschnitten der einzigen, verbleibenden Kammer vorhanden sind.

## Patentansprüche

1. Anordnung zum Entfernen von Photolack von der Oberfläche von Halbleiterscheiben, in denen integrierte Schaltungen ausgebildet sind, mit einer Einführungsvorrichtung zum Einführen einer Halbleiterscheibe in eine Behandlungskammer, einer Trockenätzvorrichtung in der Behandlungskammer, durch die der zu entfernende Photolack mittels eines Plasmas abgeätzt wird, und einer Entnahmevorrichtung, die die Halbleiterscheibe aus der Behandlungskammer entfernt, **dadurch gekennzeichnet**, daß die Einführungsvorrichtung (4), die Trockenätzvorrichtung (5, 12, 13) und die Entnahmevorrichtung (15) in einer gemeinsamen, unter Vakuum stehenden Kammer untergebracht sind, und daß die Einführungsvorrichtung (4) und die Entnahmevorrichtung (15) je ein mehrere Halbleiterscheiben enthaltendes Magazin und einen Transportarm (4a, 4b) aufweisen.

2. Anordnung nach Anspruch 1, dadurch gekennzeichnet, daß in räumlicher Nähe zur Entnahmevorrichtung (15) eine Heizvorrichtung (7) angebracht ist, durch die die Temperatur in der Umgebung der Entnahmevorrichtung (15) einstellbar ist.

## Claims

1. Arrangement for removing photoresist from the surface of semiconductor wafers in which integrated circuits have been formed, having an insertion device for introducing a semiconductor wafer into a treatment chamber, in the treatment chamber a dry etching device, by which the photoresist to be removed is etched away by means of a plasma, and a removal device, which removes the semiconductor wafer from the treatment chamber, **characterised in that** the insertion device (4), the dry etching device (5, 12, 13) and the removal device (15) are housed in a common chamber under vacuum, and the insertion device (4) and the removal device (15) each comprise a transport arm (4a, 4b) and a magazine holding a plurality of semiconductor wafers.

2. Arrangement according to claim 1, characterised in that a heating device (7), by which the temperature in the environment of the removal device (15) is adjustable, is arranged in the spatial vicinity of the removal device (15).

## Revendications

1. Agencement pour ôter de la laque photosensible de la surface de pastilles semi-conductrices, dans lesquelles des organes de couplage intégrés sont formés, comprenant un dispositif d'insertion pour insérer une pastille semi-conductrice dans une chambre de traitement, un dispositif d'attaque à sec dans la chambre de traitement, grâce auquel la laque photosensible à ôter est attaquée au moyen d'un plasma, et un dispositif d'extraction qui ôte la pastille semi-conductrice de la chambre de traitement, caractérisé en ce que le dispositif d'introduction (4), le dispositif d'attaque à sec (5, 12, 13) et le dispositif d'extraction (15) sont placés dans une chambre commune maintenue sous vide, et en ce que le dispositif d'insertion (4) et le dispositif d'extraction (15) présentent chacun un magasin contenant plusieurs pastilles semi-conductrices et un bras de transport (4a, 4b).

2. Agencement selon la revendication 1, caractérisé en ce qu'un dispositif de chauffage (7), grâce auquel la température au voisinage du dispositif d'extraction peut être ajustée, est prévu à proximité spatiale du dispositif d'extraction (15).
